Europäisches Patentamt

European Patent Office

Office européen des brevets

(19)

(11) Publication number: **0 087 707**
**A2**

(12) **EUROPEAN PATENT APPLICATION**

(21) Application number: **83101627.4**

(22) Date of filing: **21.02.83**

(51) Int. Cl.³: **H 03 K 5/13**

(30) Priority: **26.02.82 US 352671**

(43) Date of publication of application:
**07.09.83 Bulletin 83/36**

(84) Designated Contracting States:
**DE FR GB**

(71) Applicant: **Hewlett-Packard Company**
**Mail Stop 20 B-0 3000 Hanover Street**
**Palo Alto California 94304(US)**

(72) Inventor: **Hardage, Phillip Kent**
**10 Sandra Lane**
**Manitou Springs Colorado 80829(US)**

(72) Inventor: **Peurifoy, Stephen W.**
**3115 East Uintah Street**
**Colorado Springs Colorado 80909(US)**

(74) Representative: **Schulte, Knud, Dipl.-Ing.**
**c/o Hewlett-Packard GmbH Europ. Patent- und**
**Lizenzabteilung Postfach 1430 Herrenberger Strasse 130**
**D-7030 Böblingen(DE)**

(54) **Pulse delay circuit.**

(57) A pulse delay circuit uses a cascaded series of inverting elements with input thresholds to delay the transitions of an input pulse as it progresses through the series. The output of each inverter charges a capacitance in one polarity, but cannot discharge it. The discharge is achieved by current sources connected to the capacitors, charging them in a direction opposite to that of the inverter outputs. This produces a ramp which subsequently produces an abrupt transition as the ramp eventually crosses the input threshold. In this way every other inverter delays the leading edge, while the alternate intervening inverters delay the trailing edge. A final capacitance-tolerant inverting element with a threshold produces abrupt transitions for each transition as its input, to create a delayed replica of the input pulse. Asymmetries in the relative delay of the leading and trailing edges are corrected either by independently controlling one of the current sources or one of the thresholds.

./...

FIGURE 1

Int. Ref.: Case 1590          February 0087707

Hewlett-Packard Company

PULSE DELAY CIRCUIT

This invention relates to pulse delay circuits, especially for logic state analysis.

A desirable characteristic of a logic state analyzer is zero hold-time, that is, the ability to record the state of a set of logic signals at a clock transition even if the state changes immediately after the transition. In practice, the non-zero hold time of the acquisition circuitry in the analyzer requires the introduction of delay in the data acquisition path with respect to the clock acquisition path. This delay, which is typically on the order of 20 ns, has been realized in the past by placing an appropriate length of additional cable between the data acquisition probe and the analyzer circuitry. This method has the disadvantages of requiring a relatively large volume for the cable and of making it extremely difficult to optimize the delay for individual probes during production. Circuits using multivibrators can be used to produce delay, but these typically have the disadvantage of requiring the minimum acceptable input pulse width to be at least as great as the delay time.

A major object solved by the invention in view of this prior art is to provide a pulse delay circuit which requires a significantly reduced pulse width.

This object is solved according to the characterizing part of claim 1.

A particular circuit disclosed produces a delay which is adjustable by means of a single resistor, with a minimum required pulse width of no more than 70% of the total delay time. The circuit is designed to be integrated in multiple channel form on a monolithic chip.

An even number of inverting threshold circuit elements are connected in series (as in cascade coupled amplifiers). At the output of each of these is a capacitance and a current source. The output of each inverting circuit can charge the capacitance rapidly to produce abrupt output transitions of one polarity, but cannot discharge the capacitance for output transitions of the opposite polarity. This is done by the current source, which produces a ramp transition in the second polarity. The ramp transition will produce a delayed abrupt transition in the output of the next inverter in the chain, when the ramp passes through the threshold of that next inverter. Each abrupt transition at an inverter input produces a ramp at that inverter's output. In this way, within each successive pair of inverters one delays the leading edge while the other delays the trailing edge. A final circuit element capable of driving, for both polarities of transition, the nominal capacitance present at its output then provides final abrupt output transitions for both of the delayed leading and trailing edges as those final abrupt and ramp transitions at its input cross its threshold.

Figure 1 is a block diagram of an adjustable pulse delay circuit constructed with inverting elements, capacitances and current sources, in accordance with a preferred embodiment of the invention;

Figure 2 is a waveform diagram illustrating the operation of the circuit of figure 1;

Figure 3 is a more detailed diagram of the circuit of figure 1, illustrating specific means of obtaining the capacitances and current sources of the circuit of figure 1 when that circuit is implemented as an integrated circuit;

Figure 4 is a detailed schematic of certain of the inverting elements of figure 3; and

Figure 5 is a detailed schematic of another of the inverting elements of figure 3; and

Figure 6 is a generalized block diagram of a Logic State Analyzer incorporating the pulse delay circuit of figure 3 to delay state-data signals with respect to clock-data signals in order to obtain zero hold-time.

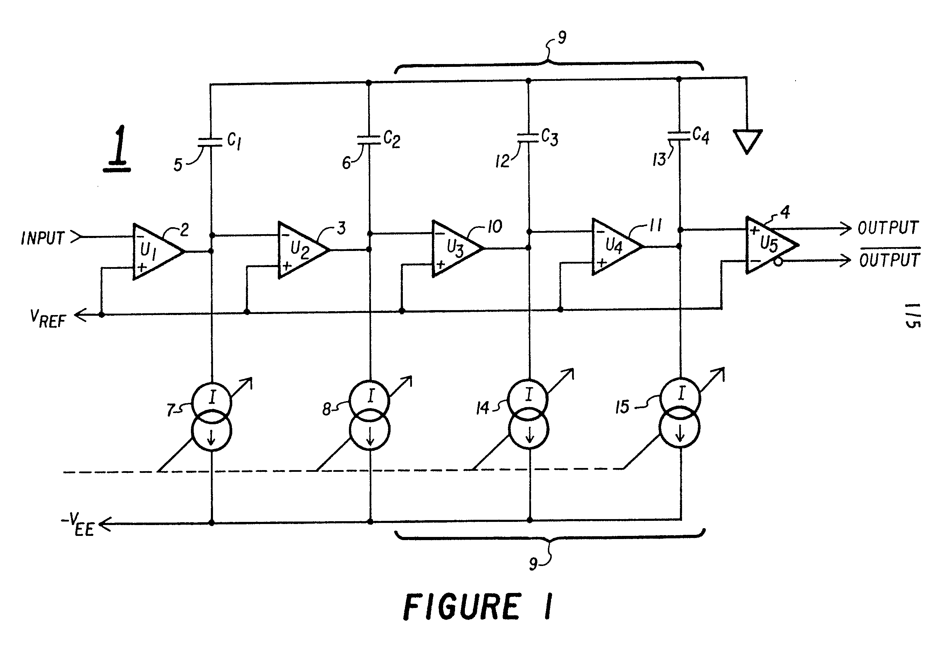

Figure 1 is a block diagram of an adjustable delay circuit 1 for digital signals that is especially well suited for fabrication in multiple-channel configurations upon an integrated circuit. It will be readily apparent to those skilled in the art, however, that the principles of the circuit of figure 1 do not depend upon either a multi-channel configuration or upon being constructed as an integrated circuit. One multi-channel integrated circuit application that has proved especially useful is an adjustable digital signal delay circuit for signals measured by the probes of a logic state analyzer. In that application ten such delay circuits 1 were fabricated upon a single chip, to provide an adjustable delay of approximately 12 ns to 40 ns, with a minimum required pulse width of no more than 70% of the selected delay. That is, the minimum pulse width varies, as a function of the selected delay, from approximately 8,4 ns to 28 ns.

The delay circuit 1 includes a basic delay state comprising gate elements 2, 3 and 4 ($U_1$, $U_2$ and $U_5$), associated capacitors 5 and 6 ($C_1$ and $C_2$), and associated adjustable current sources 7 and 8. The delay circuit 1 also includes one stage 9 of additional delay comprising gate elements 10 and 11 ($U_3$ and $U_4$), associated capacitors 12 and 13 ($C_3$ and $C_4$), and associated adjustable current sources 14 and 15. It will become apparent as the operation of the delay circuit 1 is explained that the stage 9 of additional delay may either be absent on the one hand, or, multiply repeated on the other. That is, for circuits providing a minimum range of delay the output of $U_2$ may be connected directly to the input of $U_5$, without the existence of $U_3$, $U_4$, $C_3$, $C_4$ and current sources 14 and 15. Alternatively, additional stages of delay similar or identical to stage 9 may be inserted between $U_2$ and $U_5$.

Each of gate elements $U_1$ through $U_5$ inverts the signal applied to it, provided that a certain threshold is traversed. An important characteristic of gate elements $U_1$ through $U_4$ is that each of their outputs will readily pass current in one direction, but not in the other. In the present case the output stages of each of $U_1$ through $U_4$ are emitter followers capable of supplying a large current into a capacitive load during a positive transition, resulting in a transition time not significantly greater than that of a gate not capacitively loaded. On the other hand, during a negative transition the output emitter follower essentially turns off and the transition time becomes directly proportional to the capacitance at the output, and inversely proportional to the current extracted therefrom by the external current source and the input of the next gate. By using an even number of inverting gate elements in series, both the leading and trailing edges of the input signal will at separate times be delayed by approximately the same amount. If the currents extracted from the capacitances are each varied equally, (or, if the thresholds are varied) the overall propagation delay can be adjusted over a considerable range.

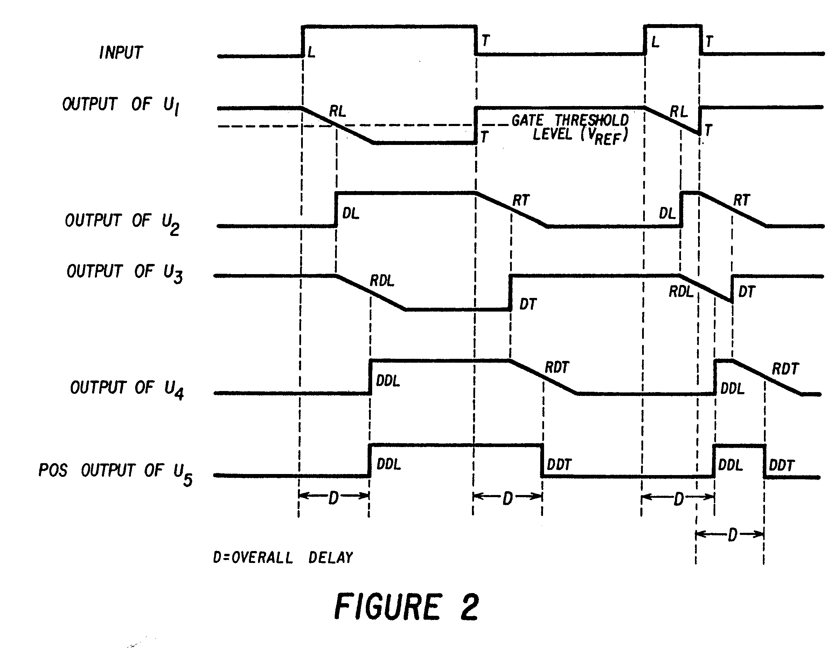

Figure 2 illustrates how an input pulse is delayed by the circuit 1 of figure 1, for some particular amount of delay D. The timing diagram of figure 2 is idealized to emphasize operation of the invention, and does not include propagation delay within a gate element itself, or the delay caused by the finite rise-times for positive-going transitions.

According to figure 2, each of positive-going leading edges L and negative-going trailing edges T for two input pulses of differing width are delayed as follows. Positive-going input leading edges L are inverted within the gate element $U_1$, and capacitance $C_1$ produces negative-going ramps RL whose slopes are determined, in part, by the current carried by current source 7. The slope of these ramps determines how much time elapses before ramp portions RL traverse the threshold of $U_2$. Once that threshold is reached the inverting action of $U_2$ quickly charges $C_2$ and produces delayed leading edges DL. Meanwhile, when the negative going input trailing edges T occured they resulted in abrupt positive transitions T at the output

of $U_1$. However, once inverted by $U_2$ those transitions produce across $C_2$ at the output of $U_2$ negative-going ramps RT. A further inversion by a capacitance-tolerant gate element would produce a delayed but inverted version of the input. A non-inverting gate element would produce simply a delayed replica of the input signal. These results could be obtained if the inputs of $U_3$ and $U_5$ were disconnected from their present locations and the input of $U_5$ connected where the input of $U_3$ had been.

If further delay is desired, then consider the further action of the circuit 1 as shown in figure 1. The inversion provided by $U_3$ and the capacitance of $C_3$ generate from the delayed positive leading edges DL negative ramps RDL. Meanwhile, $U_3$ generates delayed positive abrupt trailing edges DT. Once applied to $U_4$ these become, with the help of $C_4$, negative-going ramps RDT. As they traverse the threshold of $U_5$, these become abrupt and doubly delayed transitions DDT at the output of $U_5$. Meanwhile, $U_4$ produces DDL from ramps RDL. Because it is a positive-going signal, the DDL output from $U_4$ is unaffected by any ramp action, and the corresponding transition at the output of $U_5$ is another abrupt transition, DDL. The result is a doubly delayed replica of the input signal, or possibly its inverse, depending upon the output chosen from $U_5$.

Figure 2 demonstrates the capability of the circuit 1 to delay a pulse by an amount greater than the pulse width. The factor that guarantees this is the ability to cascade stages. Inspection of the figure clearly shows that the minimum pulse width need only be long enough to permit the slow falling edge of each gate element to cross the threshold ($V_{ref}$) and switch the following gate element.

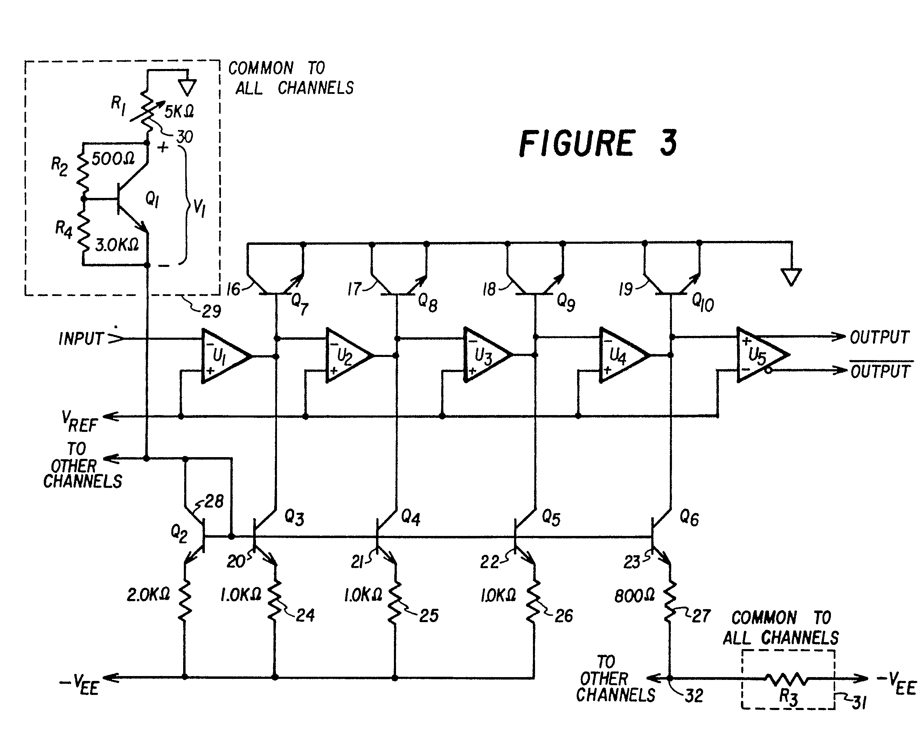

Figure 3 is a more detailed schematic diagram of the particular delay circuit 1 of figure 1. In this integrated circuit embodiment the capacitors $C_1$ through $C_4$ of figure 1 are the base-collector and base-emitter capacitances of relatively large transistors 16-19

($Q_7$ through $Q_{10}$). Also, the adjustable current sources 7-15 of figure 1 are implemented with transistors 20-23 ($Q_3$ through $Q_6$) in conjunction with associated resistors 24-27. The collector current of each of these current sources is controlled by the current supplied to a diode-connected transistor 28 ($Q_2$). That supplied current is drawn from a current adjustment circuit 29 containing an adjustable resistance 30 ($R_1$). In a monolithic integrated circuit embodiment it may be desirable to perform a permanent one-time adjustment of the value of $R_1$, such as by laser trimming. In other applications $R_1$ could actually be, or be equivalent to, a repeatedly readjustable resistance.

The adjustable delay circuit of the invention would be useful in many applications requiring a well matched set of adjustable delay lines on a single integrated circuit. The device can be made electrically adjustable by making $R_1$ a voltage-variable resistance, such as a junction FET. This would allow, for example, a control loop to be established in which the delay is dynamically adjusted to an appropriate value in response to the results of an internal test.

Within a multi-channel integrated circuit the emitter resistor of the fourth (or otherwise last) current source 15 ($Q_6$) for each channel is smaller than those of the other sources and is brought to a point 32 common to the corresponding locations in the other channels. By adjusting the value of a resistor 31 ($R_3$) connected between this common point 32 and the $-V_{EE}$ supply, the delay of a negative edge of the input signal can be adjusted independently of that of a positive edge. This allows any undesirable small asymmetries to be eliminated.

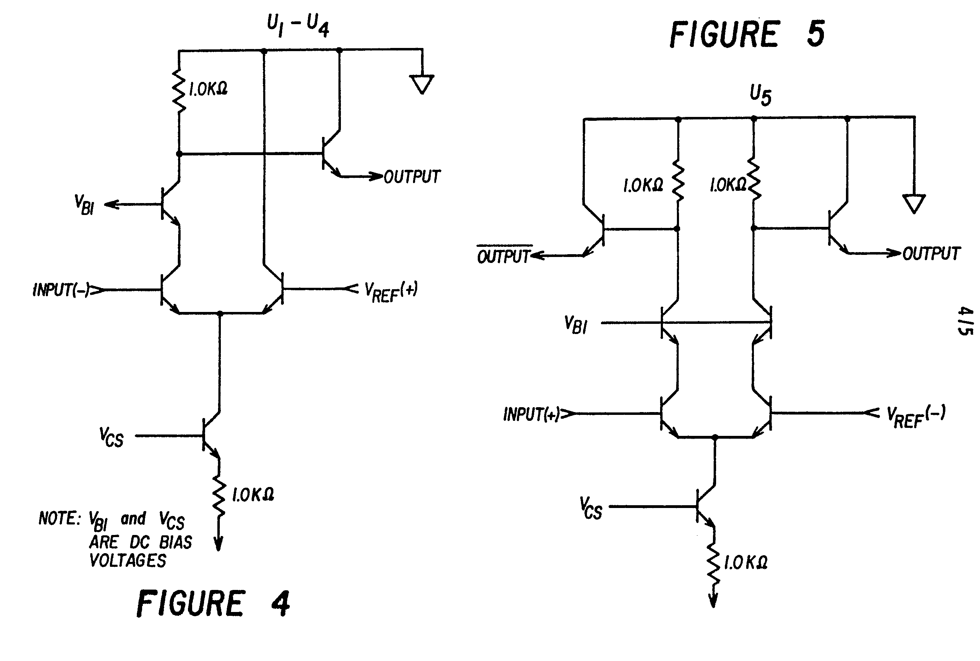

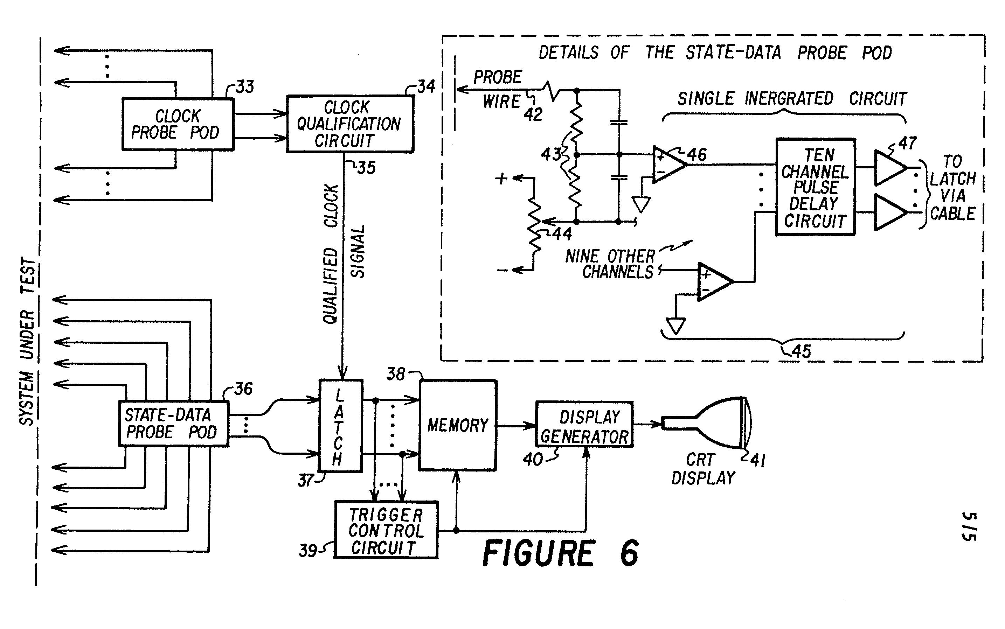

Figures 4 and 5 show the details of the circuit configuration within $U_1$-$U_4$ and $U_5$, respectively.

The propagation delay of the gate elements $U_1$-$U_5$ of figures 4 and 5 used to construct the circuit 1 of figures 1 and 3 increases slightly with rising temperature. In order to compensate for this effect the current supplied to $Q_2$ (and hence the collector currents of $Q_3$-$Q_6$) should increase slightly with temperature. This is accomplished in circuit 29 by $Q_1$, $R_2$, and $R_4$. Circuit 29 produces a voltage drop $V_1$ approximately equal to the base-emitter voltage of $Q_1$ times $(1+(R_2/R_4))$. Since the base-emitter voltage decreases at approximately 1,6 mV/°C, the temperature coefficient of $V_1$ can be varied over a range of negative values by altering the ratio of $R_2$ to $R_4$. A decreasing voltage drop $V_1$ leads to an increase in the current into $Q_2$. $Q_1$ is on the same chip as the delay circuit 1 and so responds to the same temperature changes. The ratio of $R_2$ to $R_4$ can be chosen to give an overall temperature coefficient of delay that is equal to zero.

Figure 6 illustrates a generalized block diagram of a Logic State Analyzer. A system under test (not explicitly depicted) possesses clock signals and state-data signals to be utilized by the Analyzer. A clock probe pod 33 connects the analyzer to the clock signals. The measured clock signals are fed to a clock qualification circuit 34 whose function is to generate a qualified clock signal 35 upon the occurrence of, in the measured clock signals, some criterion specified by the user. The specified criterion can be complex or trivial, depending upon the circumstance and the sophistication of the logic state analyzer.

A state-data probe pod 36 connects the logic state analyzer to the state-data signals to be measured. By delaying the output of the state-data probe pod 36 with respect to the output of the clock probe pod 33 the Logic State Analyzer can achieve zero hold time.

The qualified clock signal is used to strobe a latch 37 that captures the measured state-data. From there the measured state-data is fed to a memory 38 and a trigger control circuit 39. When certain user-selected  trigger conditions in the state-data occur
the trigger control circuit 39 halts data acquisition into the
memory 38, and a display generator 40 creates  a suitable display upon a CRT 41.

The inset of figure 6 provides additional detail concerning internal circuitry of the state-data probe pod 36 and its use of the
pulse delay circuit of figure 3. The particular state-data probe
pod 36 depicted has ten inputs. For each input a probe wire 42
connects the desired signal in the system under test to a compensated attenuator 43. This reduces the signal to a level suitable for
use by the comparison circuits. One end of the attenuator 43 is
connected to an adjustable logic reference voltage that defines
the voltage levels that will distinguish between the logic levels
of true and false. The logic reference voltage should not be confused with the threshold voltage $V_{ref}$ within the pulse delay circuit itself, as shown in figures 1 and 3. There are ten attenuators
and each of their outputs is fed to a ten-channel integrated circuit 45.

Each channel within the integrated circuit consists of a comparator 46 to discriminate between logic levels, a channel of pulse delay circuitry as previously described, and an ECL output line
driver 47 to send the delayed state-data signals over a twisted
pair cable to the remaining portion of the logic state anaylzer.

CLAIMS:

1. A pulse delay circuit characterized by first inverter means (2, 10) having an input for receiving an input pulse to be delayed and having an output for delivering in response to input pulse transitions of a first polarity crossing an input threshold an output signal through a low internal impedance that readily conducts current and for delivering in response to input pulse transitions of an opposite polarity re-crossing the input threshold a substantially higher internal impedance that essentially does not conduct current;

first capacitance means (5, 12) connected between outputs of the first inverter means and an AC ground;

first current source means (7, 14) connected to the outputs of the first inverter means for supplying a current to the first capacitance means that charges that capacitance means in a direction opposite to that caused by input pulse transitions of the first polarity;

second inverter means (3, 11) having inputs coupled to outputs of the first inverter means and having an output delivering in response to a signal transition of the first polarity crossing an input threshold an output signal through a low internal impedance that readily conducts current and for producing at its output in response to a signal transition of the opposite polarity re-crossing the input threshold a substantially higher internal impedance that essentially does not conduct current;

second capacitance means (6, 13) connected between the output of the second inverter means and an AC ground;

second current source means (8, 15) connected to the output of the inverter means, for supplying a current to the second capacitance means that charges that capacitance means in a direction opposite to that caused by signal transitions of the first polarity; and

output circuit means (4) having an input coupled to the output of the second inverter means, for delivering at its output in response to transitions of either polarity upon its input that cross a threshold an abruptly transitioning output signal whose leading and trailing edges are each delayed from the corresponding leading and trailing edges of the pulse applied to the input of the first inverter means.

2. A pulse delay circuit as in claim 1 wherein the currents supplied by the first (7, 14) and second (8, 15) current sources are independently variable.

3. A pulse delay circuit as in claim 1 or claim 2 wherein the first (2, 10) and second (3, 11) inverter means possesses emitter follower outputs.

4. A plurality of pulse delay circuits as in claim 3 fabricated within an integrated circuit and incorporating means to vary as a function of temperature the currents supplied by the first and second current sources.

5. Application of the pulse delay circuit of claim 1 or claim 2 to introduce delay into the acquisition of state-data with respect to the acquisition of clock data.

**FIGURE I**

INPUT

OUTPUT OF $U_1$

OUTPUT OF $U_2$

OUTPUT OF $U_3$

OUTPUT OF $U_4$

POS OUTPUT OF $U_5$

GATE THRESHOLD
LEVEL ($V_{REF}$)

D=OVERALL DELAY

FIGURE 2

2/5

0087707

FIGURE 3

$U_I - U_4$

1.0KΩ

OUTPUT

$V_{BI}$

INPUT(-)

$V_{REF}$(+)

$V_{CS}$

1.0KΩ

NOTE: $V_{BI}$ and $V_{CS}$
ARE DC BIAS
VOLTAGES

FIGURE 4

FIGURE 5

$U_5$

1.0KΩ    1.0KΩ

$\overline{OUTPUT}$

OUTPUT

$V_{BI}$

INPUT(+)

$V_{REF}$(-)

$V_{CS}$

1.0KΩ

4/5

0087707

DETAILS OF THE STATE-DATA PROBE POD

SINGLE INERGRATED CIRCUIT

PROBE WIRE 42

43 44

46 47

TEN CHANNEL PULSE DELAY CIRCUIT

TO LATCH VIA CABLE

NINE OTHER CHANNELS

45

CLOCK PROBE POD 33

CLOCK QUALIFICATION CIRCUIT 34

35 QUALIFIED CLOCK SIGNAL

SYSTEM UNDER TEST

STATE-DATA PROBE POD 36

LATCH 37

38 MEMORY

TRIGGER CONTROL CIRCUIT 39

40 DISPLAY GENERATOR

CRT DISPLAY 41

FIGURE 6

5/5

0087707